# EUROPÄISCHE PATENTSCHRIFT

(11) **EP 2 664 003 B1**
(45) Veröffentlichungstag und Bekanntmachung des Hinweises auf die Patenterteilung: **15.04.2020**
(21) Anmeldenummer: 12700475.2
(22) Anmeldetag: 11.01.2012
(51) Int. Cl.: H01L 31/0392

(54) **DÜNNSCHICHT-SOLARZELLEN MIT DIFFUSIONSHEMMENDER SCHICHT**
THIN FILM SOLAR CELLS HAVING A DIFFUSION-INHIBITING LAYER
CELLULES SOLAIRES EN COUCHES MINCES À COUCHE ANTI-DIFFUSION

(30) Priorität: 11.01.2011 DE 102011008269
(43) Veröffentlichungstag der Anmeldung: 20.11.2013
(73) Patentinhaber: INTERPANE Entwicklungs- und Beratungsgesellschaft mbH, 37697 Lauenförde (DE)
(72) Erfinder: KAPPERTZ, Oliver, 37077 Göttingen (DE)
(74) Vertreter: Körfer, Thomas
(86) Internationale Anmeldenummer: PCT/EP2012/050343
(87) Internationale Veröffentlichungsnummer: WO 2012/095443

(56) Entgegenhaltungen:
- WO-A1-2010/039879
- WO-A1-2010/115558
- US-A1- 2010 258 191
- GORDON R: "Chemical vapor deposition of coatings on glass", JOURNAL OF NON-CRYSTALLINE SOLIDS, NORTH-HOLLAND PHYSICS PUBLISHING. AMSTERDAM, NL, Bd. 218, 1. September 1997 (1997-09-01), Seiten 81-91, XP004095557, ISSN: 0022-3093, DOI: 10.1016/S0022-3093(97)00198-1

## Beschreibung

Die Erfindung betrifft eine Dünnschichtsolarzelle mit einer Beschichtung aus mehreren Schichten entsprechend dem Oberbegriff des Anspruchs 1.

Zur Nutzung von regenerativer Energie werden heute Photovoltaik-Zellen zur Stromerzeugung aus Sonnenlicht eingesetzt. Man unterscheidet dabei zwei Arten von Photovoltaik-Zellen. Eine Art basiert auf kristallinem Silicium, das in 0,2 - 0,4 mm dicken Scheiben als Silicium-Wafer verwendet wird. Die Zweite Art besteht aus dünnen Schichten, die auf ein Substrat aufgebracht sind, und wird als Dünnschicht-Solarzelle bezeichnet. Dünnschicht-Solarzellen können großflächig auf mehrere m² große Substrate, z.B. Glas, aufgebracht werden. Als photoaktive Schicht wird dabei beispielsweise amorphes Silicium verwendet.

Ein Problem bei solchen Dünnschicht-Solarzellen stellen aus dem Substrat diffundierende Störsubstanzen, z.B. Alkali-Ionen dar, die in darüber liegende Schichten diffundieren. Diese wirken sich auf das Kornwachstum während der Bildung der Absorberschicht aus. Eine zu große Zufuhr an Störsubstanz führt zu einem Abbau der kristallinen Kornstruktur in der photoaktiven Schicht und somit zu einem verminderten Zellstrom. Daher wird häufig eine Diffusionssperrschicht auf das Substrat aufgebracht, um die Diffusion der Störsubstanz aus dem Substrat zu unterbinden.

In der WO 2010/039880 A1 wird der Schichtaufbau auf einer Chalkopyrit-Dünnschicht-Solarzelle beschrieben. Auf einem Substrat, hier Kalknatron-Glas, wird eine Diffusionssperrschicht aufgebracht, die Natriumionen aus dem Substrat abfängt und deren Diffusion in darüber liegende Schichten verhindert. Auf der Diffusionssperrschicht ist mindestens eine Molybdän-Schicht aufgebracht, die als Rückkontakt dient. Darauf wird als photoaktives Material eine Schicht aus Kupfer, Indium und Selen (CIS) oder eine Schicht aus Kupfer, Indium, Selen und Gallium (CIGS) aufgebracht. Darauf ist wiederum eine Schicht z. B. aus Zinkoxid (ZnO) aufgebracht, die einen Frontkontakt bildet. Die Diffusionssperrschicht wird aus Siliciumoxid, Aluminiumoxid, Titanoxid, Zirkonoxid, oder Silicium- oder Titannitrid allein oder in Mischungen aus den genannten Materialien gebildet und in einer Schichtdicke bis zu 200 nm aufgebracht.

Nachteilig an einer solchen diffusionsblockierenden Schicht sind die geringe Beschichtungsrate, mit der die genannten Materialien bei der Beschichtung abgeschieden werden und der hoher Energiebedarf bei der Herstellung der Schicht.

Es ist daher die Aufgabe der Erfindung, ein Schichtsystem für eine Dünnschicht-Solarzelle zu schaffen, bei der die Diffusion von Störsubstanzen bzw. Störionen aus dem Substrat in die darüber liegenden Schichten zuverlässig unterbunden wird und dies mit einem verringerten Energieaufwand bei der Herstellung effizient und kostengünstig zu erreichen.

Die Aufgabe wird durch die erfindungsgemäße Dünnschicht-Solarzelle gemäß Anspruch 1 gelöst. In den Unteransprüchen sind vorteilhafte Weiterbildungen der erfindungsgemäßen Dünnschicht-Solarzelle dargestellt.

Die erfindungsgemäße Dünnschicht-Solarzelle umfasst ein Substrat, eine Diffusionssperrschicht sowie eine Rückkontakt-Schicht, die auf der dem Substrat abgewandten Seite der Diffusionssperrschicht angeordnet ist, sowie eine photoaktive Absorberschicht. Erfindungsgemäß ist zwischen dem Substrat und der Diffusionssperrschicht eine zusätzliche diffusionshemmende Schicht angeordnet.

Diese diffusionshemmende Schicht nimmt aus dem Substrat heraus wanderende Störsubstanzen auf, so dass lediglich eine geringe Anzahl an Störteilchen, insbesondere Ionen, an der Diffusionssperrschicht ankommen. Somit reicht eine Diffusionssperrschicht mit geringer Schichtdicke aus, um die Störteilchen aufzunehmen und eine Abgabe in die über der Diffusionssperrschicht angeordneten Schichten zu unterbinden. Da das Aufbringen der Diffusionssperrschicht mit einem hohen Energiebedarf verbunden ist, kann durch die reduzierte Schichtdicke der Diffusionssperrschicht eine erhebliche Energieeinsparung bei der Herstellung der Diffusionssperrschicht erreicht werden.

Eine solche diffusionshemmende Schicht sowie Diffusionssperrschicht ist auf metallischen Substraten, z.B. aus Edelstahl oder auf Metall- oder Alkalimetallhaltigen Substraten, wie z.B. Kalknatronglas, besonders vorteilhaft, da diese Substrate im größeren Maße Ionen abgeben. Diese beeinflussen insbesondere auch bei niedrigen Temperaturen und angelegter elektrischer Spannung die Eigenschaften der darüber liegenden Schichten und führen zu Alterungserscheinungen der Dünnfilm-Solarzelle.

Vorteilhafter Weise umfasst die diffusionshemmende Schicht Zinkoxid und Zinnoxid (ZnO)ₓ(SnO₂)_{y} mit einem Anteil von x zwischen 1,75 und 2,25, bevorzugt zwischen 1,9 und 2,1, und einem Anteil y von 0,75 bis 1,25, bevorzugt von 0,9 bis 1,1. Störsubstanzen, insbesondere die genannten Metall- oder Alkaliionen, ganz besonders Natrium-Ionen, werden in die Kristallstruktur eingelagert und von einer Weiterdiffusion abgehalten. Dies wird insbesondere durch das leicht vom stöchiometrischen Mischungsverhältnis, das bei einem Anteil von genau x=2 und einem Anteil von genau y=1 liegt, abweichenden Kombination aus Zinkoxid und Zinnoxid erreicht. Zinnoxid sowie Zinkoxid können zudem mit guter Beschichtungsrate und mit mäßigem Energieeinsatz durch physikalische Abscheideverfahren (PVD), wie z.B. Sputtern, und chemische Gasphasenabscheidung (CVD) auf das Substrat aufgebracht werden.

Eine vorteilhafte Alternative ist es, wenn die diffusionshemmende Schicht Titanoxid und/oder Zirkonoxid und/oder Hafniumoxid enthält. Ebenfalls vorteilhaft ist die Verwendung von Vanadiumoxid und/oder Nioboxid als diffusionshemmende Schicht. Die genannten Materialmischungen werden in effizienter Weise durch chemische Gasphasenabscheidung (CVD) in einer Sauerstoffatmosphäre aufgebracht.

Vorteilhafter Weise können Zinknitrid und/oder Zinnnitrid oder alternativ Titannitrid und/oder Zirkonnitrid und/oder Hafniumnitrid oder alternativ Vanadiumnitrid und/oder Niobnitrid als jeweils einzelnes Material oder als Mischung der genannten Materialien auch mit den vorstehend genannten Oxiden in der diffusionshemmenden Schicht enthalten sein.

Die Materialien werden dabei vorzugsweise durch chemische Gasphasenabscheidung unter Stickstoffatmosphäre aufgebracht. Die diffusionshemmende Schicht besitzt vorteilhafter Weise eine Schichtdicke von 10 nm bis 100 nm, bevorzugt eine Schichtdicke von 50 nm bis 60 nm.

In vorteilhafter Weise besteht die Diffusionssperrschicht aus SiOₓN_{y}C_{z} oder aus AlOₓN_{y}C_{z}. Eine solche Diffusionssperrschicht weist vorteilhafter Weise nur noch eine Schichtdicke von 10 nm bis 100 nm bevorzugt von 15 nm bis 30 nm und besonders bevorzugt von etwa 20 nm auf. Somit beträgt die Schichtdicke der Diffusionssperrschicht lediglich etwa einem Zehntel der Schichtdicke üblicher Diffusionssperrschichten. Somit kann insbesondere Energie bei der Herstellung der Dünnschicht-Solarzelle eingespart werden und die Stromgewinnung aus regenerativen Energieqellen auch ökologisch effizienter gemacht werden. Vorteilhaft ist es weiterhin auch die Rückseite des Substrats, die der vorgenannten Schichtstruktur gegenüberliegt, mit einer weiteren diffusionshemmenden Schicht und einer Diffusionssperrschicht zu versehen. Dies verhindert den Austritt von Störsubstanzen aus dem Substrat in die umgebende Luft, sodass eine Diffusion in benachbarte Dünnfilm-Solarzellen unterbunden wird.

Eine Beschichtung der Substratrückseite mit der diffusionshemmenden Schicht und der Diffusionssperrschicht ist insbesondere für Dünnschicht-Solarzellen, die auf beiden Seiten eines Substrats eine photoaktive Schicht aufweisen, vorteilhaft.

Ausführungsbeispiele der erfindungsgemäßen Dünnschicht-Solarzelle sind in der Zeichnung beispielhaft dargestellt und werden anhand der nachfolgenden Beschreibung näher erläutert. Es zeigen:
- Fig. 1: ein erstes erfindungsgemäßes Ausführungsbeispiel einer Dünnschicht-Solarzelle in schematischer Darstellung,
- Fig. 2: ein zweites erfindungsgemäßes Ausführungsbeispiel einer Dünnschicht-Solarzelle mit zusätzlicher diffusionshemmender Schicht und Diffusionsperrschicht auf der Substratrückseite und
- Fig.3: ein Diagramm mit Messergebnissen zur Wasserbeständigkeit von Glasproben mit unterschiedlicher Beschichtung.

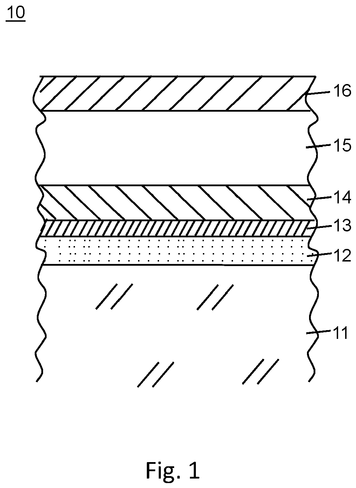

Die in Fig. 1 dargestellte Dünnschicht-Solarzelle umfasst ein Substrat 11, das z. B. aus einem metallischen Material, einer Folie und insbesondere aus Glas besteht.

Auf dem Substrat 11 ist eine diffusionshemmende Schicht 12 aufgebracht. Diese ist entweder direkt auf dem Substrat 11 aufgetragen oder durch eine oder mehrere zwischenliegende Schichten, wie z. B. einer Haftschicht, vom Substrat 11 getrennt. Über der diffusionshemmenden Schicht 12 befindet sich eine Diffusionssperrschicht 13, die aus Silicium, Sauerstoff, Stickstoff und Kohlenstoff (SiOxN_{y}C_{z}) besteht oder aus Aluminium, Sauerstoff, Stickstoff und Kohlenstoff (AlOxNyCz) besteht.

Die Diffusionssperrschicht 13 besitzt eine Schichtdicke von 10 nm bis 100 nm, bevorzugt von 15 nm bis 30 nm und besonders bevorzugt von etwa 20 nm. Die Schichtdicke der Diffusionssperrschicht 13 ist dabei geringer als die Schichtdicke der diffusionshemmenden Schicht 12, die bevorzugt eine Schichtdicke von 10 nm bis 100 nm und besonders bevorzugt von 50 nm bis 60 nm aufweist. Die Schichtdicke der beiden Schichten zusammen ist dabei in etwa gleich der Schichtdicke der bisher üblichen Diffusionssperrschicht, kann aber durch die günstigeren Beschichtungsraten (Sputterraten) und den geringeren Energiebedarf bei der Beschichtung der diffusionshemmenden Schicht 12 günstiger hergestellt werden.

Über der Diffusionssperrschicht 13 befindet sich eine Rückkontaktschicht 14, die bevorzugt aus Molybdän oder einem anderen elektrisch leitenden Element besteht. Darüber befindet sich die Halbleiter-Absorberschicht 15, in der als photoaktives Material z.B. amorphes Silicium oder, wie hier im Weiteren bevorzugt angenommen, ein Chalkopyrit-Halbleiter wie z.B. Kupfer-Indium-Selenid (CIS) oder Kupfer-Indium-Gallium-Selenid (CIGS), verwendet wird. Bei Lichteinstrahlung werden Ladungsträger in dem dort enthaltenen pn-Übergang freigesetzt und somit eine elektrische Spannung und ein elektrischer Strom erzeugt.

Auf der Absorberschicht 15 befindet sich eine Frontkontakt-Schicht 16, die wiederum aus Molybdän oder einem anderen leitenden und für sichtbares Licht bei der gewählten Schichtdicke transparenten Material besteht. Zwischen den genannten Schichten können wahlweise weitere Schichten vorhanden sein, beispielsweise eine Pufferschicht aus Cadmiumsulfid zwischen Absorberschicht 15 und Frontkontaktschicht 16. Ebenso könnte z.B. zwischen dem Substrat 11 und der diffusionshemmenden Schicht 12 eine Haftvermittlungsschicht vorhanden sein.

Am Beispiel einer Dünnschicht-Solarzelle 10 mit einer Kalknatron-Glasscheibe als Substrat 11 und einer CIGS-Absorberschicht 15 wird die Wirkung der Störsubstanz, in diesem Fall insbesondere von Natriumionen, aufgezeigt. Für das Wachstum der CIGS-Absorberschicht 15 ist Natrium vorteilhaft, da dieses die Bereiche, in denen das Absorbermaterial in kristalliner Form vorliegt, vergrößert. Diese Natriumionen können entweder aus dem Kalknatron-Glas stammen oder gezielt durch Dotierung der Rückkontakt-Schicht 14 mit Natrium oder z.B. durch das Aufbringen einer NaF-Schicht auf die Rückkontakt-Schicht 14 zugesetzt werden.

Um einerseits den Natrium-Gehalt exakt einstellen zu können und andererseits eine kontinuierliche Diffusion von Natriumionen aus dem Substratglas in die darüber liegenden Schichten zu vermeiden, werden im Ausführungsbeispiel eine diffusionshemmende Schicht 12 und eine Diffusionssperrschicht 13 eingesetzt, die die Natriumionen besonders aufnehmen und binden. Dies verhindert insbesondere die Diffusion von Natrium bei niedrigen Temperaturen und angelegter elektrischer Spannung, die zu Alterungseffekten in der Solarzelle und insbesondere in der Absorberschicht 15 führen. Die diffusionshemmende Schicht 12 unterstützt dies effizient und ermöglicht eine beträchtliche Energieersparnis bei der Herstellung der Schichten der Dünnschicht-Solarzelle 10.

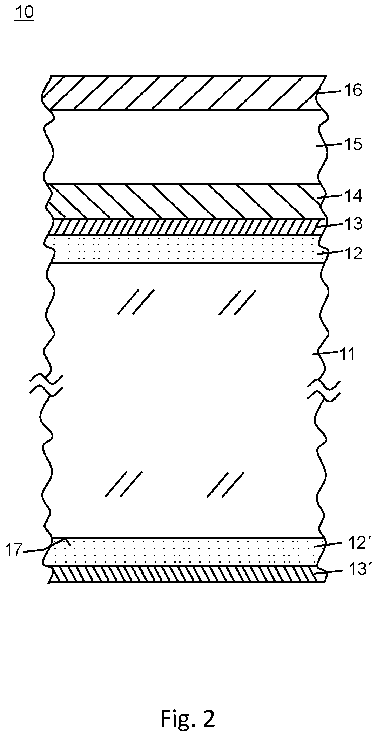

Fig. 2 zeigt ein weiteres erfindungsgemäßes Ausführungsbeispiel. Eine Kontamination von benachbarten Solarzellen durch die Übertragung der Störsubstanz wird durch eine weitere diffusionshemmende Schicht 12', und/oder eine weitere Diffusionssperrschicht 13' ebenso wirksam vermindert. Die weitere diffusionshemmende Schicht 12' und die weitere Diffusionssperrschicht 13' ist dabei auf der Rückseite des Substrats 11, die der Absorberschicht gegenüberliegt, angeordnet.

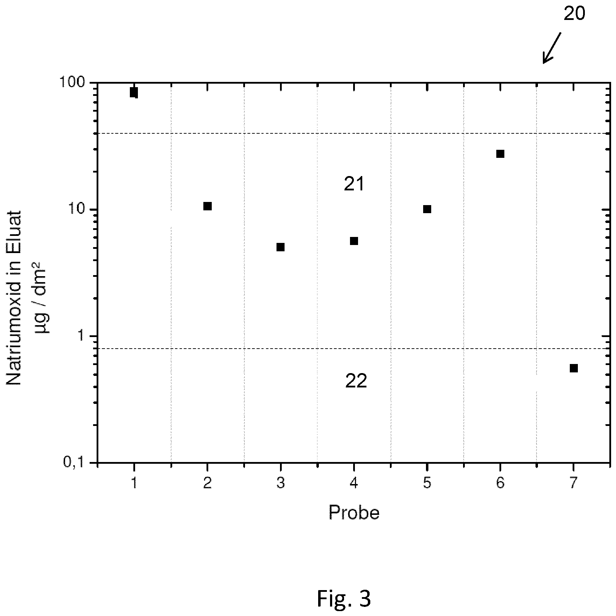

Fig. 3 zeigt ein Diagramm 20 mit Messergebnissen zur Wasserbeständigkeit einer Oberfläche von verschiedenen Glasproben bei 98°C nach DIN 52296. In x-Richtung sind die vermessenen Proben vermerkt, in y-Richtung ist die aus der Probenoberfläche ausgelöste Menge an Natriumoxid in µg pro dm² aufgetragen. An der Oberfläche einer unbeschichteten Floatglasscheibe, siehe Probe 1, tritt ca. 80 µg/dm² gelöstes Natrium aus. Floatglasscheiben mit diffusionshemmender Schicht 12 einer Schichtdicke d, siehe Probe 2 bis 6, weisen dagegen eine deutlich geringere Natriumoxidmenge pro dm² als die unbeschichtete Probe 1 auf. Diffusionshemmende Schichten 12 liegen in Diagramm 20 im Bereich 21 zwischen 40 µg/dm² und 0,8 µg/dm² Natriumoxid, der durch die gestrichelten Linien begrenzt ist. Allgemein liegen diffusionshemmende Beschichtungen im Bereich 21 und weisen eine um den Faktor 0,01 bis 0,5 niedrigere Ausschwemmung von Natriumoxid aus einem Glassubstrat auf als bei einem unbeschichten Glassubstrat.

Eine Floatglasscheibe mit einer Diffusionssperr-Schicht 13 gleicher Schichtdicke d, siehe Probe 7, weist lediglich eine Natriumoxidausschwemmung von ca. 0,6 µg/dm² auf und liegt damit in einem diffusionssperrenden Bereich 22, der eine Natriumoxidausschwemmung geringer als der 0,01-fachen Wert einer unbeschichteten Probe aufweist.

## Patentansprüche

1. Dünnschicht-Solarzelle umfassend
ein Substrat (11), eine Diffusionssperrschicht (13), eine Rückkontakt-Schicht (14), die auf der dem Substrat (11) abgewandten Seite der Diffusionssperrschicht (13) angeordnet ist, und eine photo-aktive Absorberschicht (15),
**dadurch gekennzeichnet,**
**dass** zwischen Substrat (11) und Diffusionssperrschicht (13) eine diffusionshemmende Schicht (12) angeordnet ist, und dass die Diffusionssperrschicht (13) aus Silicium, Sauerstoff, Stickstoff und Kohlenstoff (SiOₓN_{y}C_{z}) besteht, oder dass die Diffusionssperrschicht (13) aus Aluminium, Sauerstoff, Stickstoff und Kohlenstoff (AlOₓN_{y}C_{z}) besteht, und dass die Schichtdicke der Diffusionssperrschicht (13) kleiner als die Schichtdicke der diffusionshemmenden Schicht (12) ist,
und **dass** auf der Rückseite des Substrats (17), die der Absorberschicht (15) gegenüberliegt, eine weitere diffusionshemmende Schicht (12') und/oder eine weitere Diffusionssperrschicht (13') aufgebracht ist.

2. Dünnschicht-Solarzelle nach Anspruch 1,
**dadurch gekennzeichnet,**
**dass** in dem Substrat (11) eine Störsubstanz, insbesondere Natrium vorhanden ist, und die Diffusionssperrschicht (13) die Diffusion der Ionen der Störsubstanz in die über der Diffusionssperrschicht (13) angeordneten Schichten verhindert.

3. Dünnschicht-Solarzelle nach Anspruch 1 oder 2,
**dadurch gekennzeichnet,**
das die Absorberschicht (15) ein Chalkopyrit, das Kupfer, Indium, Selen und/oder Gallium enthält, umfasst.

4. Dünnschicht-Solarzelle nach einem der Ansprüche 1 bis 3,
**dadurch gekennzeichnet,**
das die diffusionshemmende Schicht (12) Zinkoxid und Zinnoxid (ZnO)ₓ(SnO₂)_{y} mit einem Anteil von x zwischen 1,75 und 2,25, bevorzugt zwischen 1,9 und 2,1, und einem Anteil y von 0,75 bis 1,25, bevorzugt von 0,9 bis 1,1, enthält und/oder
dass die diffusionshemmende Schicht (12) Titanoxid und/oder Zirkonoxid und/oder Hafniumoxid enthält und/oder
dass die diffusionshemmende Schicht (12) Vanadiumoxid und/oder Nioboxid enthält
und/oder
dass die diffusionshemmende Schicht (12) Zinknitrid und/oder Zinnnitrid enthält
und/oder
dass die diffusionshemmende Schicht (12) Titannitrid und/oder Zirkonnitrid und/oder Hafniumnitrid enthält und/oder
dass die diffusionshemmende Schicht (12) Vanadiumnitrid und/oder Niobnitrid enthält.

5. Dünnschicht-Solarzelle nach einem der Ansprüche 1 bis 4,
**dadurch gekennzeichnet,**
**dass** die Absorberschicht (15) auf der Rückkontakt-Schicht (14) angeordnet ist und/oder eine Frontkontakt-Schicht (16), die auf der Absorberschicht (15) angeordnet ist, vorhanden ist.

6. Dünnschicht-Solarzelle nach einem der Ansprüche 1 bis 5,
**dadurch gekennzeichnet,**
**dass** die diffusionshemmende Schicht (12) eine Schichtdicke von 10 nm bis 100nm, bevorzugt von 50 nm bis 60nm, besitzt.

7. Dünnschicht-Solarzelle nach einem der Ansprüche 1 bis 6,
**dadurch gekennzeichnet,**
**dass** die Diffusionssperrschicht (13) eine Schichtdicke von 10 nm bis 100nm, bevorzugt von 15 nm bis 30nm, besonders bevorzugt von ca. 20nm, aufweist.

8. Dünnschicht-Solarzelle nach einem der Ansprüche 1 bis 7,
**dadurch gekennzeichnet,**
**dass** durch ein Substrat mit diffusionshemmender Schicht einer bestimmten Dicke eine um den Faktor 0,01 bis 0,5 niedrigere Natriumoxidmenge pro dm² austritt als durch ein unbeschichtetes Substrat und durch ein Substrat mit einer Diffusionssperrschicht der gleichen Dicke eine Natriumoxidmenge pro dm² austritt, die unter dem 0,01-fachen Wert einer unbeschichteten Probe liegt.

## Claims

1. Thin-film solar cell comprising a substrate (11), a diffusion barrier layer (13), a rear contact layer (14) which is arranged on the side of the diffusion barrier layer (13) facing away from the substrate (11), and a photoactive absorber layer (15),
**characterized in that**
a diffusion-inhibiting layer (12) is arranged between substrate (11) and diffusion barrier layer (13) and **in that** the diffusion barrier layer (13) consists of silicon, oxygen, nitrogen and carbon (SiOₓN_{y}C_{z}), or **in that** the diffusion barrier layer (13) consists of aluminium, oxygen, nitrogen and carbon (AlO_{X}N_{y}C_{z}), and **in that** the layer thickness of the diffusion barrier layer (13) is less than the layer thickness of the diffusion-inhibiting layer (12), and **in that** a further diffusion-inhibiting layer (12') and/or a further diffusion barrier layer (13') has been applied to the rear side of the substrate (17) opposite the absorber layer (15).

2. Thin-film solar cell according to Claim 1,
**characterized in that**
an interfering substance, in particular sodium, is present in the substrate (11) and the diffusion barrier layer (13) prevents diffusion of the ions of the interfering substance into the layers arranged above the diffusion barrier layer (13) .

3. Thin-film solar cell according to Claim 1 or 2,
**characterized in that**
the absorber layer (15) comprises a chalcopyrite containing copper, indium, selenium and/or gallium.

4. Thin-film solar cell according to any of Claims 1 to 3,
**characterized in that**
the diffusion-inhibiting layer (12) contains zinc oxide and
tin oxide (ZnO)ₓ(SnO₂)_{y} with a proportion of x in the range from 1.75 to 2.25, preferably from 1.9 to 2.1, and a proportion of y of from 0.75 to 1.25, preferably from 0.9 to 1.1,
and/or
**in that** the diffusion-inhibiting layer (12) contains titanium oxide and/or zirconium oxide and/or hafnium oxide and/or
**in that** the diffusion-inhibiting layer (12) contains vanadium oxide and/or niobium oxide
and/or
**in that** the diffusion-inhibiting layer (12) contains zinc nitride and/or tin nitride
and/or
**in that** the diffusion-inhibiting layer (12) contains titanium nitride and/or zirconium nitride and/or hafnium nitride
and/or
**in that** the diffusion-inhibiting layer (12) contains vanadium nitride and/or niobium nitride.

5. Thin-film solar cell according to any of Claims 1 to 4,
**characterized in that**
the absorber layer (15) is arranged on the rear contact layer (14) and/or a front contact layer (16) which is arranged on the absorber layer (15) is present.

6. Thin-film solar cell according to any of Claims 1 to 5,
**characterized in that**
the diffusion-inhibiting layer (12) has a layer thickness of from 10 nm to 100 nm, preferably from 50 nm to 60 nm.

7. Thin-film solar cell according to any of Claims 1 to 6,
**characterized in that**
the diffusion barrier layer (13) has a layer thickness of from 10 nm to 100 nm, preferably from 15 nm to 30 nm, particularly preferably about 20 nm.

8. Thin-film solar cell according to any of Claims 1 to 7,
**characterized in that**
an amount of sodium oxide per dm² which is lower by a factor of from 0.01 to 0.5 exits through a substrate having a diffusion-inhibiting layer having a particular thickness than through an uncoated substrate and an amount of sodium oxide per dm² which is less than 0.01 times the value for an uncoated specimen exits through a substrate having a diffusion barrier layer having the same thickness.

## Revendications

1. Cellule solaire en couches minces comprenant
un substrat (11), une couche barrière anti-diffusion (13), une couche de contact arrière (14), qui est disposée sur la face, opposée au substrat (11), de la couche barrière anti-diffusion (13), et une couche absorbante (15) photo-active,
**caractérisée en ce**
**qu'**une couche anti-diffusion (12) est disposée entre le substrat (11) et la couche barrière anti-diffusion (13), et que la couche barrière anti-diffusion (13) est constituée de silicium, d'oxygène, d'azote et de carbone (SiOₓN_{y}C_{z}), ou que la couche barrière anti-diffusion (13) est constituée d'aluminium, d'oxygène, d'azote et de carbone (AlOₓN_{y}C_{z}),
et **que** l'épaisseur de couche de la couche barrière anti-diffusion (13) est plus petite que l'épaisseur de couche de la couche anti-diffusion (12),
et **qu'**une autre couche anti-diffusion (12') et/ou une autre couche barrière anti-diffusion (13') est appliquée sur la face arrière du substrat (17) qui est opposée à la couche absorbante (15).

2. Cellule solaire en couches minces selon la revendication 1,
**caractérisée en ce**
**qu'**une substance parasite, en particulier du sodium, est présente dans le substrat (11), et la couche barrière anti-diffusion (13) empêche la diffusion des ions de la substance parasite dans les couches disposées sur la couche barrière anti-diffusion (13).

3. Cellule solaire en couches minces selon la revendication 1 ou 2,
**caractérisée en ce**
**que** la couche absorbante (15) comprend une chalcopyrite, qui contient du cuivre, de l'indium, du sélénium et/ou du gallium.

4. Cellule solaire en couches minces selon l'une quelconque des revendications 1 à 3,
**caractérisée en ce**
**que** la couche anti-diffusion (12) contient de l'oxyde de zinc et de l'oxyde d'étain (ZnO)ₓ(SnO₂)_{y} avec une proportion de x comprise entre 1,75 et 2,25, de préférence entre 1,9 et 2,1, et une proportion y de 0,75 à 1,25, de préférence de 0,9 à 1,1, et/ou
**que** la couche anti-diffusion (12) contient de l'oxyde de titane et/ou de l'oxyde de zirconium et/ou de l'oxyde de hafnium
et/ou
**que** la couche anti-diffusion (12) contient de l'oxyde de vanadium et/ou de l'oxyde de niobium
et/ou
**que** la couche anti-diffusion (12) contient du nitrure de zinc et/ou du nitrure d'étain
et/ou
**que** la couche anti-diffusion (12) contient du nitrure de titane et/ou du nitrure de zirconium et/ou du nitrure de hafnium
et/ou
**que** la couche anti-diffusion (12) contient du nitrure de vanadium et/ou du nitrure de niobium.

5. Cellule solaire en couches minces selon l'une quelconque des revendications 1 à 4,
**caractérisée en ce**
**que** la couche absorbante (15) est disposée sur la couche de contact arrière (14) et/ou une couche de contact avant (16), qui est disposée sur la couche absorbante (15), est présente.

6. Cellule solaire en couches minces selon l'une quelconque des revendications 1 à 5,
**caractérisée en ce**
**que** la couche anti-diffusion (12) possède une épaisseur de couche de 10 nm à 100 nm, de préférence de 50 nm à 60 nm.

7. Cellule solaire en couches minces selon l'une quelconque des revendications 1 à 6,
**caractérisée en ce**
**que** la couche barrière anti-diffusion (13) présente une épaisseur de couche de 10 nm à 100 nm, de préférence de 15 nm à 30 nm, de manière particulièrement préférée d'environ 20 nm.

8. Cellule solaire en couches minces selon l'une quelconque des revendications 1 à 7,
**caractérisée en ce**
**qu'**une quantité d'oxyde de sodium par dm² sort plus basse du facteur 0,01 à 0,5 par un substrat avec une couche anti-diffusion d'une épaisseur définie que par un substrat non revêtu, et une quantité d'oxyde de sodium par dm² qui se situe au-dessous de 0,01 fois la valeur d'un échantillon non revêtu sort par un substrat avec une couche barrière anti-diffusion de même épaisseur.
